# EUROPEAN PATENT APPLICATION

(11) **EP 4 776 773 A2**
(43) Date of publication of application: **15.07.2026**
(21) Application number: 25226185.4
(22) Date of filing: 22.12.2025
(51) Int. Cl.: H05K 7/20

(54) **ELECTRONIC DEVICE**

(30) Priority: 10.01.2025 JP 2025003937
(71) Applicant: Alps Alpine Co., Ltd., Ota-ku, Tokyo 145-8501 (JP)
(72) Inventor: Yabuki, Kiminori, Iwaki-city Fukushima (JP); Zhuang, Changlong, Dalian City, Liaoning Province (CN); Lin, Xiaolin, Dalian City, Liaoning Province (CN); Han, Jiajun, Dalian City, Liaoning Province (CN)
(74) Representative: Schmitt-Nilson Schraud Waibel Wohlfrom Patentanwälte Partnerschaft mbB

(57) **Abstract**

Provided is an electronic device capable of effectively cooling heat radiated from a heat-generating electronic component provided in a case by a heat sink, and inhibiting any impact on electronic circuits and the like by moisture intruding into the case. A heat sink provided inside the case has a plurality of protrusions extending perpendicularly toward a facing wall part of the case. Air entering the case from a first air intake hole formed in the facing wall part is dispersed and periodically diffused by the protrusions, and exhausted outside via a gas exhaust hole by a power fan. Moisture intruding into the case is drained downward through a water draining path along upper surfaces of a first bank part and a second bank part.

## Description

The present application claims priority to Japanese Patent Application No. 2025-003937, filed January 10, 2025.

The present invention relates to an electronic device packed in a case in which an airflow can be formed, such that heat conducted from a heat-generating electronic component to a heat sink can be released to the outside of the case.

The fan-less heat dissipation mechanism described in JP 2019-21772A includes a heat sink. The heat sink has a base, which has a plurality of pin fins and a plurality of plate-like fins, and a cover. The plurality of pin fins are arranged in a matrix formation in a region overlapping a heat-generating component, and the plurality of plate-like fins are arranged radially from the region where the pin fins are arranged. An opening is formed in the cover, and the plurality of pin fins are exposed from the opening. When the air in the region where the pin fins are provided is warmed by heat from the heat-generating component, an upward airflow rising through the opening of the cover is generated.

As the air rises, air is drawn into a space between the base and the cover via four side surfaces, and natural convection is generated along the plate-like fins.

According to the heat sink described in JP 2017-11203A, a plurality of rectangular fins extending in the direction of gravity are erected on a base, and rows of pin fins extending in a direction orthogonal to gravity are provided between the rectangular fins. Paragraph [0023] reads that the convection performance is improved through optimization of the number of the rectangular fins and the number of the rows of pin fins.

According to the fan-less heat dissipation mechanism described in JP 2019-21772A, the plurality of pin fins are used only to generate an upward airflow toward the opening in the cover, and the plurality of pin fins do not exhibit a function for agitating the air or dispersing the air toward the periphery. Further, there is a problem that moisture tends to stagnate on the heat sink when the moisture intrudes into the device from the opening or the four side surfaces.

According to the heat sink described in JP 2017-11203A, the air resistance between the rectangular fins is large for the rows of pin fins arranged in a narrow region between the adjacent rectangular fins. Therefore, it is difficult to increase the flow velocity of the air, and the cooling effect of an airflow cannot be expected very much. Further, no countermeasures against moisture intruding from the outside are implemented.

The present invention was made in view of the conventional problems described above, and an object of the present invention is to provide an electronic device capable of enhancing an air-cooling effect by diffusing, by a plurality of protrusions on a heat sink, air sucked into a case from an air intake hole, and dispersing the air to the periphery.

It would also be beneficial to provide an electronic device capable of draining moisture intruding into a case from the outside, without allowing the moisture to stagnate on the surface of a heat sink.

The present disclosure relates to an electronic device according to the appended claims. Embodiments are disclosed in the dependent claims.

According to an aspect, the present invention provides an electronic device, including: a heat-generating electronic component; and a heat sink, both housed in a case of the electronic device,
wherein the case includes:
   a facing wall part including an air intake hole; and
   a gas exhaust hole opened at a position apart from the air intake hole,
wherein a power fan configured to form, between the heat sink and the facing wall part, an airflow flowing from the air intake hole to the gas exhaust hole is provided,
wherein the heat sink includes a plurality of protrusions each having a height dimension greater than a maximum width dimension of the protrusion at a base end of the protrusion, a distal end of each of the protrusions being directed to the facing wall part, and
wherein the air intake hole faces a region within a protrusion arrangement region in which the plurality of protrusions are arranged, and an area of the protrusion arrangement region is greater than an opening area of the air intake hole.

In the electronic device of the present invention, the heat sink may have a heat-dissipation flat surface facing the facing wall part, and the plurality of protrusions extend perpendicularly from the heat-dissipation flat surface.

In the electronic device of the present invention, it is preferable that each of the plurality of protrusions has a cross-section that has a circular, ovular, or elliptical shape, and that has a uniform size from the base end to the distal end.

According to a further aspect, the present invention also provides an electronic device including: a heat-generating electronic component; and a heat sink both housed in a case of the electronic device,
wherein the case includes:
   a facing wall part extending in a vertical direction;
   a first side wall part extending vertically while intersecting with the facing wall part;
   a second side wall part extending vertically while facing the first side wall part;
   an air intake hole opened in the first side wall part; and
   a gas exhaust hole opened in the second side wall part, and
wherein the heat sink includes:
   a plurality of protrusions directed to the facing wall part;
   a first bank part located under the protrusions and extending from an inner side of the first side wall part in a direction intersecting with the first side wall part; and
   a water draining path continuous with the first bank part and extending in a downward direction.

In the electronic device of the present invention, it is preferable that the heat sink has a second bank part extending from an inner side of the second side wall part to the water draining path.

Further, it is preferable that at least one of the first bank part or the second bank part is inclined in a direction to descend to the water draining path.

In the electronic device of the present invention, each of the plurality of protrusions may have a height dimension greater than a maximum width dimension of the protrusion at a base end of the protrusion, and the plurality of protrusions may be provided in parallel with each other.

In the electronic device of the present invention, it is preferable that each of the plurality of protrusions has a cross-section that has a circular, ovular, or elliptical shape, and that has a uniform size from the base end to a distal end.

Further, it is preferable that the electronic device of the present invention includes a power fan configured to form, between the heat sink and the facing wall part, an airflow flowing from the air intake hole to the gas exhaust hole.

In the electronic device according to aspects of the present invention, the plurality of protrusions provided on the heat sink are directed to the facing wall part, and the area of the protrusion arrangement region is greater than the opening area of the air intake hole opened in the facing wall part. Therefore, air drawn into between the heat sink and the facing wall part from the air intake hole is diffused by the plurality of protrusions positioned immediately under the air intake hole, and is effectively dispersed to the periphery, thereby making it possible to effectively form an airflow that takes away heat from the heat sink.

In the electronic device according to aspects of the present invention including the facing wall part extending in the vertical direction and the heat sink on the inner side of the facing wall part, the heat sink has the bank part and the water draining path under the plurality of protrusions directed to the facing wall part. Therefore, it is possible to drain any moisture intruding together with air sucked from the air intake hole, without allowing the moisture to stagnate on the surface of the heat sink.

### BRIEF DESCRIPTION OF THE DRAWINGS

FIG. 1 is an oblique view of an electronic device according to an embodiment of the present invention viewed from the left;
FIG. 2 is an oblique view of an electronic device according to an embodiment of the present invention viewed from the right;
FIG. 3 is an exploded oblique view of an electronic device according to an embodiment of the present invention viewed from the left;
FIG. 4 is a partially exploded oblique enlarged view of a part of an electronic device according to an embodiment of the present invention viewed from the left;
FIG. 5 is a front view of an electronic device according to an embodiment of the present invention, as seen through a facing wall part; and
FIG. 6 is a cross-sectional side view of the electronic device shown in FIG. 1 taken along the line VI-VI.

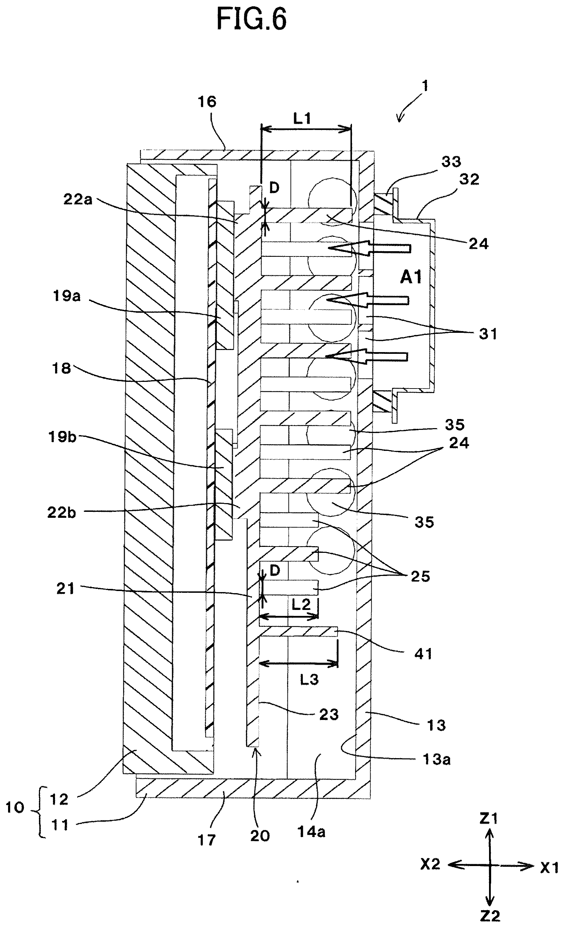

An electronic device 1 shown in each drawing is a vehicle-mounted electronic device, and is, for example, a vehicle-mounted infotainment device. In each drawing, the X1-X2 is the front-rear direction, and the X1 direction is the frontward direction and the X2 direction is the rearward direction. The Y1-Y2 direction is the left-right direction, and the Y1 direction is the leftward direction and the Y2 direction is the rightward direction. The Z1-Z2 direction is the vertical or upper-lower direction, and the Z1 direction is the upward direction and the Z2 direction is the downward direction. As shown in FIG. 6, the electronic device 1 is used by being installed in a vertically-long attitude such that a facing wall part 13 of a case and a heat-dissipation flat surface 23 of a heat sink 20 extend in the vertical direction (in parallel with the Y-Z plane). Alternatively, the facing wall part 13 and the heat-dissipation flat surface 23 may be installed inclinedly counterclockwise from the attitude shown in FIG. 6.

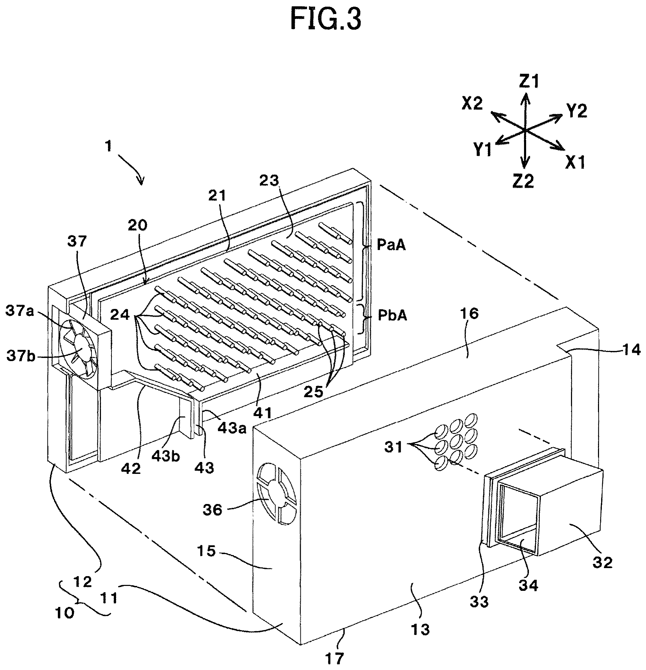

As shown in FIGS. 3 and 6, the electronic device 1 includes a case 10. The case 10 is a combined structure of a front case 11 and a rear case 12. The case 10 has a rectangular parallelepiped shape. The front case 11 has a facing wall part 13 positioned on the front side (X1 side) and extending in the vertical direction, a first side wall part 14 intersecting the facing wall part 13 perpendicularly rearward (in the X2 direction) on the right side (Y2 side) of the facing wall part 13, and a second side wall part 15 intersecting the facing wall part 13 perpendicularly rearward (in the X2 direction) on the left side (Y1 side) of the facing wall part 13. The first side wall part 14 and the second side wall part 15 face each other in parallel in the left-right direction (Y1-Y2 direction). An inner surface 13a (see FIG. 6) of the facing wall part 13 facing the inner side of the case 10 is a flat surface parallel with the Y-Z plane, and an inner surface 14a (see FIG. 6) of the first side wall part 14 and an inner surface of the second side wall part 15 are flat surfaces parallel with the X-Z plane. As shown in FIG. 3, the front case 11 has an upper wall part 16 and a lower wall part 17. The upper wall part 16 and the lower wall part 17 are flat plates parallel with the X-Y plane.

As shown in FIG. 6, the rear case 12 functions as a base, and the rear case 12 is housed and fixed inside a rear part of the front case 11. A circuit board 18 is fixed in a front part of the rear case 12. A plurality of electronic components are mounted on the circuit board 18, and the electronic components include heat-generating electronic components 19a and 19b. The heat-generating electronic components 19a and 19b are provided inside the case 10. The heat-generating electronic components 19a and 19b are ICs that are constituent components of an image generation circuit and a power source circuit.

A heat sink 20 is housed inside the case 10. The heat sink 20 is made of a metal having a high thermal conductivity, such as aluminum, an aluminum alloy, and the like. As shown in FIG. 6, the heat sink 20 includes a flat plate-shaped base part 21, and heat-receiving parts 22a and 22b protruding rearward (in the X2 direction) are formed on the base part 21. The rear surface of the heat-receiving part 22a is in contact with the front surface of the heat-generating electronic component 19a, and the rear surface of the heat-receiving part 22b is in contact with the front surface of the heat-generating electronic component 19b.

A surface of the heat sink 20 provided on the front side of the base part 21 is the heat-dissipation flat surface 23. The heat-dissipation flat surface 23 is a flat surface parallel with the Y-Z plane and is parallel with the inner surface 13a of the facing wall part 13. Inside the case 10, a space sandwiched between the heat-dissipation flat surface 23 and the inner surface 13a of the facing wall part 13 functions as a "heat-dissipation space". The heat sink 20 is formed integrally with a plurality of protrusions 24 and 25 protruding from the heat-dissipation flat surface 23 toward the inner surface 13a of the facing wall part 13.

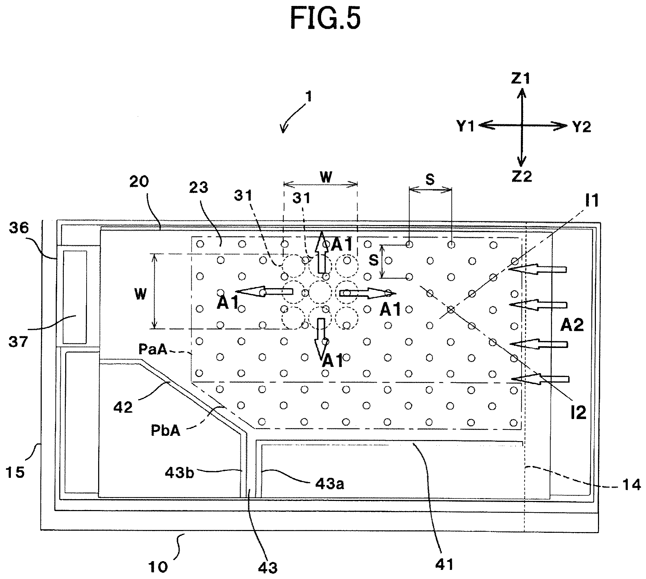

As shown in FIGS. 3 and 5, an upper part of the heat-dissipation flat surface 23 of the heat sink 20 is an upper protrusion arrangement region PaA, and a lower part of the heat-dissipation flat surface 23 is a lower protrusion arrangement region PbA. The upper protrusion arrangement region PaA is provided with the plurality of protrusions 24, and the lower protrusion arrangement region PbA is provided with the plurality of protrusions 25. The protrusions 24 and 25 are formed integrally with the heat sink 20. As shown in FIG. 5, the protrusions 24 and 25 are arranged in the vertical direction (Z1 to Z2 direction) and in the left-right direction (Y1 to Y2 direction) with the same constant interval dimension S. Therefore, the protrusions 24 and 25 are also arranged at constant intervals in an I1 line direction and an I2 line direction inclined by 45 degrees from the vertical direction and the left-right direction as well. The number of the protrusions 25 arranged in the vertical direction is less than the number of the protrusions 24 arranged in the vertical direction. In the embodiment of FIG. 5, the number of the rows of the protrusions 25 is three as counted from the bottom, and the area of the upper protrusion arrangement region PaA is greater than the area of the lower protrusion arrangement region PbA.

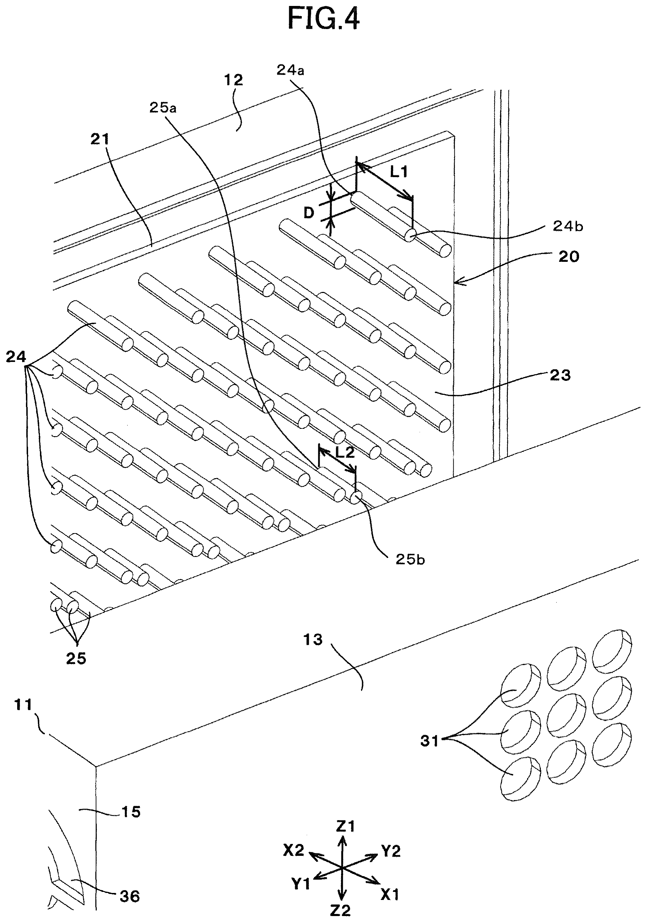

As shown in FIGS. 4 and 6, each of the protrusions 24 provided in the upper protrusion arrangement region PaA is what is generally referred to as a pin-shaped fin having a height dimension L1 from a base end 24a to a distal end 24b that is greater than the maximum width dimension D of the protrusion 24 at the base end 24a, which is the boundary with the heat-dissipation flat surface 23. Each of the protrusions 25 provided in the lower protrusion arrangement region PbA is also what is generally referred to as a pin-shaped fin having a height dimension L2 from a base end 25a to a distal end 25b that is greater than the maximum width dimension D of the protrusion 25 at the base end 25a. However, the height dimension L2 of the protrusions 25 in the lower protrusion arrangement region PbA is less (shorter) than the height dimension L1 of the protrusions 24 in the upper protrusion arrangement region PaA. The protrusions 24 and 25 have the same maximum width dimension D.

The protrusions 24 and 25 both have a circular cross-sectional shape at the base ends 24a and 25a, and a constant cross-section from the base ends 24a and 25a to the distal ends 24b and 25b. It is preferable that the height dimensions L1 and L2 of both the protrusions 24 and 25 are equal to or greater than three times, more preferably equal to or greater than five times the maximum width dimension D of the protrusions 24 and 25. The protrusions 24 and 25 may be formed with a cross-sectional area (maximum width dimension) that gradually decreases from the base ends 24a and 25a to the distal ends 24b and 25b. The protrusions 24 and 25 according to the embodiment have a truly circular cross-sectional shape, but the cross-sectional shape may be elliptical, ovular, or rectangular.

The distal ends 24b of the plurality of protrusions 24 provided in the upper protrusion arrangement region PaA and the distal ends 25b of the plurality of protrusions 25 provided in the lower protrusion arrangement region PbA are directed to the inner surface 13a of the facing wall part 13. As shown in FIGS. 3, 4, and 5, first air intake holes 31 are formed in the facing wall part 13. The first air intake holes 31 are an aggregate of a plurality of truly circular holes. The first air intake holes 31 communicate with the "heat-dissipation space" between the heat-dissipation flat surface 23 of the heat sink 20 and the inner surface 13a of the facing wall part 13. However, the first air intake holes 31 may be composed of one large hole. As shown in FIG. 5, the first air intake holes 31 face the upper protrusion arrangement region PaA, and the upper protrusion arrangement region PaA is more expansive than the opening region in which the first air intake holes 31 are opened (a region having a width dimension W×W shown in FIG. 5) in all of the upward, downward, left, and right directions. The area of the upper protrusion arrangement region PaA is greater than the sum of the opening areas of the first air intake holes 31, and than the area of the opening region (W×W). Furthermore, the sum of the area of the upper protrusion arrangement region PaA and the area of the lower protrusion arrangement region PbA is greater than the sum of the opening areas of the first air intake holes 31, and than the area of the opening region.

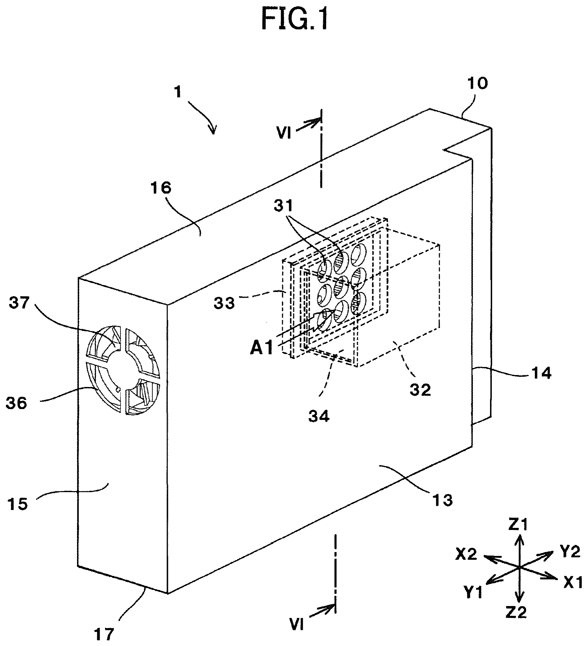

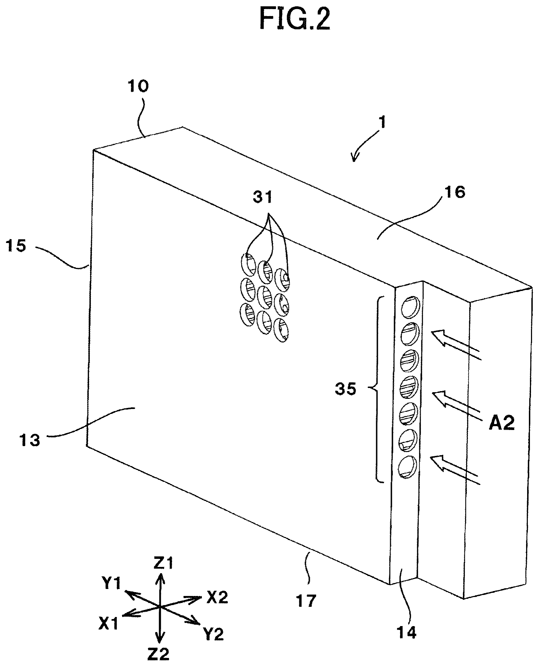

As shown in FIGS. 1, 3 and 6, a duct 32 is attached to the front surface (outer surface) of the facing wall part 13 of the front case 11. The duct 32 is not shown in FIGS. 2 and 4. A gasket 33 is provided on the front surface of the facing wall part 13 so as to surround the first air intake holes 31, and the duct 32 is fixed to the front surface of the gasket 33. The duct 32 is screwed and fixed to the facing wall part 13. An air inlet 34 opened in the left direction (Y1 direction) is opened in the duct 32. A cold air hose extending from an air conditioner of a vehicle is connected to the air inlet 34 of the duct 32.

As shown in FIGS. 2 and 6, second air intake holes 35 are formed in the first side wall part 14 of the front case 11. The second air intake holes 35 are composed of a plurality of truly circular holes, and the respective holes are provided at regular intervals in the Z1-Z2 direction along the vertical direction of the first side wall part 14. The second air intake holes 35 communicate with the "heat-dissipation space" between the heat-dissipation flat surface 23 of the heat sink 20 and the inner surface 13a of the facing wall part 13. The holes constituting the second air intake holes 35 face both the upper protrusion arrangement region PaA and the lower protrusion arrangement region PbA from the right side (Y2 side). When viewed in the cross-sectional view of FIG. 6, the height dimension L1 of the protrusions 24 and the height dimension L2 of the protrusions 25 are set to be long so as to enable the protrusions 24 and 25 to face the second air intake holes 35 from the interior of the case.

As shown in FIGS. 1 and 3, a gas exhaust hole 36 is opened in the second side wall part 15 of the front case 11. The gas exhaust hole 36 faces the second air intake holes 35 in the left-right direction (Y1-Y2 direction). A power fan 37 facing the inner side of the gas exhaust hole 36 is provided inside the case 10. The power fan 37 includes a rotating fan 37a and a powering part 37b having a motor for rotating the rotating fan 37a. By the rotation of the rotating fan 37a provided in the power fan 37, an airflow flowing from the first air intake holes 31 to the gas exhaust hole 36 is formed in the "heat-dissipation space", and an airflow flowing from the second air intake holes 35 to the gas exhaust hole 36 is formed. The power fan 37 may be provided on the inner side of the first air intake holes 31 and on the inner side of the second air intake holes 35 to form airflows flowing to the gas exhaust hole 36.

As shown in FIGS. 5 and 6, the heat sink 20 is provided with a first bank part 41 protruding frontward (in the X1 direction) from the heat-dissipation flat surface 23. The first bank part 41 is located under the upper protrusion arrangement region PaA and the lower protrusion arrangement region PbA. The first bank part 41 extends from the inner side of the inner surface 14a of the first side wall part 14 in the left direction (in the Y1 direction), which is a direction intersecting the first side wall part 14. In the cross-section shown in FIG. 6, the first bank part 41 extends frontward (in the X1 direction) perpendicularly from the heat-dissipation flat surface 23 of the heat sink 20 and closes the "heat-dissipation space" from the lower side. The protruding height dimension L3 of the first bank part 41 from the heat-dissipation flat surface 23 is equal to or greater than 1/2 the height dimension L1 of the protrusions 24 and greater than the height dimension L2 of the protrusions 25. The heat sink 20 is formed integrally with a second bank part 42 protruding frontward from the heat-dissipation flat surface 23. The second bank part 42 extends from the inner side of the second side wall part 15 in the right direction (Y2 direction) intersecting the second side wall part 15.

As shown in FIG. 5, a water draining path 43 extending vertically is formed on the heat-dissipation flat surface 23 of the heat sink 20. The water draining path 43 is formed between a water path wall part 43a continuing from the first bank part 41 and a water path wall part 43b continuing from the second bank part 42. The first bank part 41 extends toward the water draining path 43, the second bank part 42 extends toward the water draining path 43, and the water draining path 43 is formed continuously with the first bank part 41 and the second bank part 42. As shown in FIG. 5, the first bank part 41 is formed horizontally in the left-right direction, while the second bank part 42 is provided inclined so as to descend toward the water draining path 43. Conversely, the second bank part 42 may be horizontal, and the first bank part 41 may be inclined so as to descend toward the water draining path 43. Alternatively, both the first bank part 41 and the second bank part 42 may be inclined so as to descend toward the water draining path 43.

Hereinafter, the heat-dissipation effect that is exhibited when the electronic device 1 operates will be described.

When the electronic device 1 operates, heat radiated from the heat-generating electronic components 19a and 19b shown in FIG. 6 is conducted to the heat sink 20 via the heat-receiving parts 22a and 22b. When the electronic device 1 operates, the power fan 37 operates, and the rotation of the rotating fan 37a forms an airflow flowing from the first air intake holes 31 toward the gas exhaust hole 36 and an airflow flowing from the second air intake holes 35 toward the gas exhaust hole 36 in the "heat-dissipation space" between the heat-dissipation flat surface 23 and the facing wall part 13. The heat accumulated in the heat sink 20 is transferred to the air in the "heat-dissipation space" via the heat-dissipation flat surface 23 and the protrusions 24 and 25 that are pin-shaped fins, and is released to the external space of the electronic device 1 from the gas exhaust hole 36 by the airflows in the "heat-dissipation space".

The temperature inside the vehicle is high in the summer. Here, while the air conditioner mounted on the vehicle is operating, cold air is introduced into the "heat-dissipation space" from the first air intake holes 31 through the duct 32 and the cold air hose extending from the air conditioner. While the air conditioner is operating, the cold air is introduced into the "heat-dissipation space" from the first air intake holes 31, and at the same time, the air inside the vehicle is introduced into the "heat-dissipation space" from the second air intake holes 35. When the air conditioner does not operate because the season is other than the summer or for other reasons, the air inside the vehicle is introduced into the "heat-dissipation space" from both the first air intake holes 31 and the second air intake holes 35.

As shown in FIGS. 5 and 6, the "protrusion arrangement region" composed of the upper protrusion arrangement region PaA and the lower protrusion arrangement region PbA is present expansively from the opening region of the first air intake holes 31 in all of the upward, downward, left, and right directions, and the protrusions 24 and 25 are arranged in the left-right direction (Y1-Y2 direction) and in the vertical direction (Z1-Z2 direction) with the interval dimension S being less than the width dimension W in each direction within the Y-Z plane of the opening region of the first air intake holes 31. Further, the protrusions 24 and 25 are also regularly arranged at constant intervals in the I1 line direction and in the I2 line direction inclined by 45 degrees from the left-right direction.

Since the plurality of protrusions 24 extend perpendicularly toward the facing wall part 13 and toward the first air intake holes 31, as shown in FIG. 6, the air A1 having passed through the first air intake holes 31 is introduced into the "heat-dissipation space" at a high flow rate without being significantly resisted by the plurality of protrusions 24. The air A1 having flowed into the space at a high flow rate collides with the heat-dissipation flat surface 23 of the heat sink 20, and flows in the left-right direction and the vertical direction, as well as in oblique directions, as shown in FIG. 5. The air A1 flowing along the heat-dissipation flat surface 23 is agitated by the plurality of protrusions 24 and 25 arranged scatteringly from the opening region of the first air intake holes 31 toward the periphery, spreads while being dispersed toward the periphery, and flows to the gas exhaust hole 36 in the dispersed state. Since the cold air from the air conditioner flows while being dispersed, the heat can be effectively taken away from the protrusions 24, which can enhance the cooling effect by the heat sink 20.

As shown in FIG. 6, the second air intake holes 35 include a plurality of holes, and these holes are opened so as to face substantially the entireties of the upper protrusion arrangement region PaA and the lower protrusion arrangement region PbA from the right side. As shown in FIG. 5, the air A2 drawn into the "heat-dissipation space" from the second air intake holes 35 by the rotation of the rotating fan 37a is dispersed by colliding with the plurality of protrusions 24 provided in the upper protrusion arrangement region PaA and the protrusions 25 provided in the lower protrusion arrangement region PbA, and flows in the left direction (Y1 direction) while also being diffused in the vertical direction (Z1-Z2 direction). The first bank part 41 extending in the left direction and the second bank part 42 are provided under the lower protrusion arrangement region PbA, and the second bank part 42 extends obliquely upward toward the gas exhaust hole 36. Since a flow path sandwiched between the upper wall part 16 of the case 10 and the first bank part 41 from above and below is formed, the air A2 introduced from the second air intake holes 35 hardly escapes in the downward direction and the like, and flows leftward with a fast fluid force. Furthermore, since the second bank part 42 extends obliquely toward the gas exhaust hole 36, the air A2 is guided to the power fan 37 by the second bank part 42, and the airflow flowing leftward is easily formed in the upper protrusion arrangement region PaA and the lower protrusion arrangement region PbA. This air A2 can also take away heat effectively from the protrusions 24 and the protrusions 25, and can enhance the cooling effect of the heat sink 20.

When moisture flows into the case 10 from the second air intake holes 35 while the electronic device 1 is operating or stopped, the moisture flows downward along the heat-dissipation flat surface 23 of the heat sink 20 and is received by the first bank part 41. Therefore, the moisture can be prevented from reaching the electronic circuits mounted on the circuit board 18. When a large amount of moisture intrudes into the case 10, the moisture received by the upper surface of the first bank part 41 can be released downward through the water draining path 43 continuous from the first bank part 41, and the moisture can be prevented from reaching the electronic circuits. When the electronic device 1 is stopped, there is a case where moisture may intrude into the case 10 from the gas exhaust hole 36. However, similarly, this moisture travels the upper surface of the inclined second bank part 42 and is released downward through the water draining path 43. Therefore, the electronic circuits are less likely to be affected by the moisture.

The first bank part 41 and the second bank part 42 formed integrally with the heat sink 20 function as guides for forming a flow path by guiding air introduced into the "heat-dissipation space" in the case 10, and also exert a function for damming up the moisture intruding into the case 10 and guiding it to the water draining path 43.

## Claims

1. An electronic device, comprising: a heat-generating electronic component; a power fan; and a heat sink, the heat-generating electronic component and the heat sink being housed in a case of the electronic device,
wherein the case comprises:
a facing wall part including an air intake hole; and
a gas exhaust hole opened at a position apart from the air intake hole,
wherein the power fan is configured to form, between the heat sink and the facing wall part, an airflow flowing from the air intake hole to the gas exhaust hole,
wherein the heat sink comprises a plurality of protrusions each having a height dimension greater than a maximum width dimension of the protrusion at a base end of the protrusion, a distal end of each of the protrusions being directed to the facing wall part, and
wherein the air intake hole faces a region within a protrusion arrangement region in which the plurality of protrusions are arranged, and an area of the protrusion arrangement region is greater than an opening area of the air intake hole.

2. The electronic device according to claim 1,
wherein the heat sink has a heat-dissipation flat surface facing the facing wall part, and the plurality of protrusions extend perpendicularly from the heat-dissipation flat surface.

3. The electronic device according to claim 1 or 2,
wherein each of the plurality of protrusions has a cross-section that has a circular, ovular, or elliptical shape, and that has a uniform size from the base end to the distal end.

4. An electronic device, comprising: a heat-generating electronic component; and a heat sink, the heat-generating electronic component and the heat sink being housed in a case of the electronic device,
wherein the case comprises:
a facing wall part extending in a vertical direction;
a first side wall part extending vertically while intersecting with the facing wall part;
a second side wall part extending vertically while facing the first side wall part;
an air intake hole opened in the first side wall part; and
a gas exhaust hole opened in the second side wall part, and
wherein the heat sink comprises:
a plurality of protrusions directed to the facing wall part;
a first bank part located under the plurality of protrusions and extending from an inner side of the first side wall part in a direction intersecting with the first side wall part; and
a water draining path continuous with the first bank part and extending in a downward direction.

5. The electronic device according to claim 4,
wherein the heat sink comprises a second bank part extending from an inner side of the second side wall part to the water draining path.

6. The electronic device according to claim 5,
wherein at least one of the first bank part or the second bank part is inclined in a direction to descend to the water draining path.

7. The electronic device according to one of claims 4 to 6,
wherein each of the plurality of protrusions has a height dimension greater than a maximum width dimension of the protrusion at a base end of the protrusion, and
wherein the plurality of protrusions are provided in parallel with each other.

8. The electronic device according to claim 7,
wherein each of the plurality of protrusions has a cross-section that has a circular, ovular, or elliptical shape, and that has a uniform size from the base end to a distal end.

9. The electronic device according to one of claims 4 to 8,
wherein a power fan configured to form, between the heat sink and the facing wall part, an airflow flowing from the air intake hole to the gas exhaust hole is provided.
